# EUROPEAN PATENT SPECIFICATION

(11) **EP 2 463 031 B1**
(45) Date of publication and mention of the grant of the patent: **20.04.2016**
(21) Application number: 11192830.5
(22) Date of filing: 09.12.2011
(51) Int. Cl.: B05D 5/06, B05D 7/02

(54) **Method of preparing sandwich composite coating on engineering plastic surface**
Verfahren zur Herstellung einer Schalenverbundstoffbeschichtung auf einer Baukunststoffoberfläche
Procédé de préparation de revêtement composite en sandwich sur une surface plastique à ingénierie

(30) Priority: 10.12.2010 CN 201010585736
(43) Date of publication of application: 13.06.2012
(73) Proprietor: Xiamen Runner Industrial Corporation, Xiamen 361021 (CN)
(72) Inventor: Wu, Zi-Bao, 361021 Xiamen (CN); Lee, Min-Zen, 361021 Xiamen (CN)
(74) Representative: Lang, Christian

(56) References cited:
- WO-A1-2008/156224
- US-A- 5 656 335
- US-B1- 6 251 334

## Description

### BACKGROUND OF THE INVENTION

### 1. Field of the invention

The present invention relates to a method of forming a metal composite layer on an engineering plastic surface, in particular to a full-dry method of preparing a sandwich composite coating on an engineering plastic surface.

### 2. Description of Related Art

Products featuring high corrosion, abrasion resistance, flat mirror-surface and decoration can be produced by wet plating a plastic surface, and plastic metallization (plated Cu/Ni/Cr metal film) has been used extensively for a long time. However, the wet plating technology has the following drawbacks: (1) consuming much water and power and producing a large quantity of wastewater; (2) using toxic chemical electrolytes and additives; (3) discharging toxic waste gases; (4) consuming a large quantity of metal; (5) using hexavalent chromium which is harmful to human health; and (6) requiring a high-standard substrate surface, and providing a limited scope of applicability. Obviously, this prior art causing tremendous environmental pollutions and hazards requires improvements. Related researchers and manufacturers spare no effort to improve the conventional wet plating technology and achieve some preliminary results. The dry coating technology is well developed, and its applications have substituted some of the plastic plated products. In an automobile wheel cap coating method as disclosed in P.R.C. Pat. No. CN 101338409, the method comprises pre-processing, primer paint curing, ion-bombardment chromium plating, and finish paint light curing steps. The patented invention adopts a dry coating method to substitute the traditional wet electroplating method and an aluminum layer to substitute the traditional Ni-Cu-Cr metal coating. The dry coating method has the advantages of using no toxic matters, requiring no waste treatments, involving a simple manufacturing process, as well as causing no environmental pollution. In addition, the dry coating method has less bad impacts on workers' health since the workers can work under better working conditions. The method does not require any use of noble metals such as copper, nickel and chromium, but just uses a small quantity of aluminum and incurs a significantly lower cost, an easier technique, and a simpler manufacturing procedure. In this method, the power consumption is approximately equal to 1/5∼1/7 of that of the electroplating method, the water consumption is approximately equal to 1/10∼1/20 of that of the electroplating method, and the overall production cost is approximately equal to 1/2 of that of the electroplating method. Obviously, the method of the present invention is cost-effective and improves the conventional dispersing and mixing techniques by adding nano ceramic particles into a light curing finish paint material to enhance the surface abrasion resistance.

A surface treatment method applicable for metals and non-metals was disclosed in P.R.C. Pat. No. CN1468976, this patented technology overcomes the serious environmental pollution problem of the conventional surface treatment method, but the products so produced have the drawbacks of poor corrosion resistance and low surface luster. As a result, a conductive fixed rack is developed for positioning objects, and the objects are fixed onto the fixed rack, wherein a primer film is coated onto the objects, and then vacuumed and electroplated to form a metal plated layer. The fixed rack together with the objects are electrically coated, so that the surface of the plated layer becomes an acrylic layer having high corrosion resistance and abrasion resistance to overcome the existing problems of the conventional surface treatment method. The aforementioned dry coating also adopts an electrophoretic coating as the finish paint. However, the dry coating technology still has the following problems and drawbacks:
1. Most of the rising and degreasing procedures still require the use of chemicals and discharge wastewater.
2. Defects such as spots, precipitates, greases, air bubbles, protrusions and recessions, rough surfaces, streaks, and scratches formed on the surface of the film-coating blank are unavoidable when this dry coating technology is used, and this technology requires a high-standard substrate surface of the blank and fails to manufacture a highlight plat mirror-surface product easily.
3. The organic coating on the surface is exposed to the outside, and the coating has poor weather resistance and water resistance.
4. The outermost layer is made of an organic substance instead of a metal film, so that the coating has a decreased hardness and lacks the texture of metal.
5. The interfaces between a plastic part and a primer paint, a primer paint and a metal film, and a metal film and a finish paint are lack of an activation process, so that the binding forces between layers are insufficient and not stable enough.
6. The spray of primer paint and finish paint is required, thus causing a low yield rate, a high emission of VOC, and a bad impact on environment protection.
7. The coating has a stricter requirement of the primer paint, and different substrates require different primer paints. The choice of primer paints is very limited. For some new materials, no corresponding primer paint is available.

US 6,251,334 B1 describes a composite construction made of a substrate, a polymer layer and an inorganic layer. In order to improve adhesion of the inorganic layer on the polymeric layer, the polymeric layer includes inorganic filler material.

WO 2008/1565224 A1 describes a laminated structure including a blank provided with metal layers and insulation layers which are disposed in alternative order one onto the other. The insulation layers are provided in order to avoid changes of optical and electrical characteristics in dependency of temperature changes. However, if there are defects on the surface of the blank, these defects negatively influence the luster properties of the laminated structure.

Starting from this state of the art, it is the object of the present invention to provide a method for preparing a sandwich composite coating on an engineering plastic surface which results in improved luster properties even in case of using a blank having defects on its surface.

### SUMMARY OF THE INVENTION

The objective of the present invention is to overcome the drawbacks of the conventional dry coating method by providing an environmentally friendly and water-saving method of preparing a sandwich composite coating on an engineering plastic surface, and the method can achieve the effects of improving the function and quality of a plastic coated metal product, lowering the production cost, and using no liquid water in the entire manufacturing process.

The above-mentioned objects are solved by the method according to claim 1. Advantageous improvements of the invention are subject matter of dependant claims.

The method of the present invention comprises the following steps:
(1) A plastic blank is dry cleaned and activated.
   In the step (1), the plastic blank is made of thermoplastic or thermosetting plastic, and the thermoplastic is one selected from the group of ABS, PC/ABS, HIPS, PC, PPO, PP, PBT, PPS, PERT, HDPE, PA6, PA66, ABS/TPU and PMMA and fiberglass reinforced ABS, PC/ABS, HIPS, PC, PPO, PP, PBT, PPS, PERT, HDPE, PA6, PA66, ABS/TPU, and PMMA, and the thermosetting plastic is BMC. In the dry cleaning of the plastic blank, the plastic blank is wiped by a dry cloth and then placed into an electrostatic dust remover to blow away the dust. In the activation process, the cleaned plastic blank is transferred into a physical vapor deposition (PVD) furnace and processed by a plasma gas glow activation.
(2) The activated plastic blank is placed into the PVD furnace and a metal basal film is formed on the activated plastic blank.
   In the step (2), the metal is one selected from the group of copper, nickel, chromium, aluminum, stainless steel, zirconium and titanium, and metal compounds of copper, nickel, chromium, aluminum, stainless steel, zirconium and titanium. The metal basal film layer has a thickness falling within a range of 0.05∼3µm. The metal basal film M1 of the activated plastic blank has a vacuum pressure of 5×10⁻³Pa, and the time for coating metal on the basal film layer falls within a range of 5∼60min. The metal is coated onto the basal film layer by sputtering, arc plating or evaporation deposition.
(3) A plasma activation of the plastic blank is performed after the metal is coated onto the basal film layer, and then an organic coating is sputtered.
   In the step (3), the organic coating has a thickness falling within a range of 5~60µm, and the organic coating is sputtered by the following method:
   After the ion source in the PVD furnace is turned on, a protective gas is passed, and a plasma glow activation of the metal basal film layer is performed, the plastic blank is removed from the PVD furnace and transferred to a spray rotating line and sputtered with a light curing paint (UV) or baked paint layer, and then sent into an infrared oven for leveling and baking dry the spray paint layer, and the plastic blank is placed in an ultraviolet curing furnace and processed by a radiation curing crosslink or thermal curing crosslink.
   The protective gas can be nitrogen, argon or oxygen; the plasma glow activation time falls within a range of 2~10min; the paint layer has a thickness falling within a range of 5~60µm; the baking temperature falls within a range of 40~80 °C; the baking time falls within a range of 3~10min; the radiation curing crosslink time falls within a range of 10~45s; the thermal curing crosslink temperature falls within a range of 70~180°C, the thermal curing crosslink time falls within a range of 10~90min; and the organic coating is sputtered by a liquid spray, electrophoretic deposition or powder spray method.
(4) The plastic blank obtained from the Step (3) is placed into PVD and coated with a metal film layer to obtain a metalized engineering plastic product.
   In the step (4), the metal film layer has a thickness falling within a range of 0.05~3µm; the metal is copper, nickel, chromium, aluminum, stainless steel, zirconium or titanium, or a metal compound of copper, nickel, chromium, aluminum, stainless steel, zirconium or titanium; and the metal film layer is coated by a method as described below:

The plastic blank is transferred into a PVD furnace, an ion source is turned on, a protective gas is passed over, a plasma glow activation of the cured spray paint layer is performed; the ion source is turned off, an arc target is turned on, and a sputtering of the target or a steam source is supplied for coating a metal film.

The protective gas can be nitrogen, argon or oxygen; the plasma glow activation time falls within a range of 2~10min; and the chromium arc plating time falls within a range of 5~60min.

Since the coating of the present invention includes two metal layers, and an organic coating included between the two metal layers, the coating of the invention is called a sandwich composite coating, wherein the organic coating is provided for leveling the surface of the blank and covering defects formed on the surface of the blank to improve the luster of the product. Therefore, the present invention can be used to substitute the conventional wet electroplating method.

Tests show that the metalized engineering plastic product produced in accordance with the present invention not only has the advantages of being corrosion resistant, abrasion resistant, weather resistant, temperature resistant and ability to be multiple colors, but also provides a hard smooth surface with a quality comparable to the plastic products produced by the conventional wet electroplating, dispelling the need for roughening via conventional wet electroplating, and activation via a water rinsing process, and no harmful electrolytes are used, particularly the toxic hexavalent chromium. In addition, the invention consumes a small quantity of metal, discharges insignificant waste gas, and results in no release of wastewater in the process. The invention provides an economic and environmentally friendly coating technology to open up the field of plastic metallization and produce plated products with excellent functions and good appearance. The invention is suitable for the sanitary ware, electronics, electric appliance and automobile industries.

### BRIEF DESCRIPTION OF THE DRAWINGS

The invention, as well as its many advantages, may be further understood by the following detailed description and a related drawing in which:

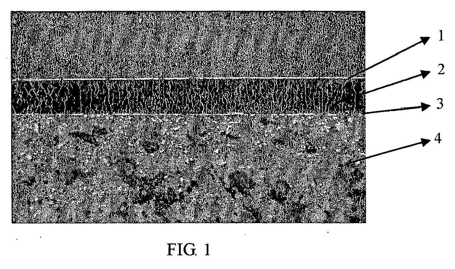

Fig. 1 is a cross-sectional view (amplified by 400X) of an included composite coating formed on an engineering plastic surface in accordance with a preferred embodiment of the present invention.

### DETAILED DESCRIPTION OF THE INVENTION

In the first preferred embodiment, a chromium plated PC/ABS mirror casing is provided for the illustration of the present invention.
(1) A blank is formed by injecting PC/ABS for the injection molding, and sent into a physical vapor deposition (PVD) furnace and rinsed and activated by a plasma source glow (provided that the current is 0.3A, the bias voltage is 100V, the flow of argon is 30SCCM, the flow of oxygen is 20SCCM, the vacuum pressure inside the furnace is 0.1Pa, and the activation time is 5 min).
(2) The arc target in the PVD furnace is turned on, chromium is plated on a surface of a PC/ABS blank (provided that the current of the target source is 60A, the bias voltage is 100V, the flow of argon is 50SCCM, the vacuum pressure inside the furnace is 0.1Pa, and the chromium plating time is 12 min).
(3) After the metal basal film is plated with chromium, the surface of the blank is activated by plasma (provided that the current of the ion source is 0.3A, the bias voltage is 100V, the flow of the working gases is a mixed flow of Ar₂ and O₂, and the activation time is 5 min).
(4) Empty the blank from the furnace, and spray a UV paint of 10µm thick onto the blank, and bake the painted layer by an IR lamp at 60°C for 5 min. and then cure the blank by an UV lamp at 1000J/m²×20s.
(5) The photo-cured blank is transferred into the PVD furnace and processed by a plasma gas activation (provided that the current of the ion source is 0.3A, the bias voltage is 100V, the vacuum pressure inside the furnace is 0.2Pa, the flow of the working gases is a mixed flow of Ar₂ and O₂, the mixing ratio is 50SCCM: 50SCCM, and the activation time is 5 min); and then a 0.2µm-thick Cr layer is coated onto the paint surface (wherein the arc plating conditions include: the current of the chromium target is 60A, the bias voltage is 100V, the flow of Ar₂ is 30SCCM, the vacuum pressure is 0.2Pa, and the coating time is 20 min).

The product produced by this technology has a smooth and flat surface and passes the following functional tests:
(A) CASS Corrosion Resistance: 8h;
(B) Thermal Shock Loop: 4 loops;
(C) Falling Sand Impact: 12L of falling sand;
(D) Adhesion (Cross Cut): 5A;
(E) Water immersion at 38°C: 24h;
(F) Pencil Hardness (Mitsubishi): 2H;
(G) RCA Abrasion Resistance Test: 450 times.

In the second preferred embodiment, an ABS plated nickel mirror frame is used as an example.
(1) ABS is injected to form a blank, and the blank is sent into a PVD furnace and processed by plasma gas rinsing (provided that the current of the ion source current is 1A, the bias voltage is 100V, the vacuum pressure is 0.1Pa, the working gas is 50SCCM of Ar₂, and the activation time is 3 min).
(2) A mid-frequency nickel target is provided in the PVD furnace, and nickel is plated onto a surface of the plastic blank (provided that the current of the target power is 10A, the bias voltage is 90V, the vacuum pressure is 0.1Pa, and the flow of the working gases is a mixed flow of 30SCCM of Ar₂ and 20SCCM of O₂, and the time for plating nickel is 10min).
(3) A plasma activation of the surface of the plastic blank is performed after nickel is plated (onto the metal basal film) (provided that the current of the ion source is 1A, the bias voltage is 90V, the flow of the working gas is a mixed flow of Ar₂ and N₂, the mixing ratio is 50 SCCM: 50SCCM, the vacuum pressure is 0.2Pa, and the activation time is 5min).
(4) The blank is removed from the furnace, and sprayed with a 25µm-thick layer of UV paint. An IR lamp is used to bake the painted layer at 60 for 5 min, and then an UV lamp is used for curing (1100J/m²×25s).
(5) The light-cured blank is transferred and hung in a PVD furnace and processed by a plasma gas activation (provided that the current of the ion source is 1A, the bias voltage is 100V, the vacuum pressure inside the furnace is 0.2Pa, the flow of the working gas is a mixed flow of Ar₂ and N₂, the mixing ratio is 50 SCCM: 50SCCM, and the activation time is 5 min). An imitation nickel surface with a thickness of 0.1µm is coated onto the painted surface (wherein the imitation nickel coating conditions include: the current of the zirconium target is 70A, the bias voltage is 100V, the vacuum pressure of passing 300SCCM of N₂ and 100SCCM of Ar₂ is 0.5Pa, and the time of coating the film is 10 min).

The product produced according to the aforementioned technology has a shiny mirror surface and passes the following functional tests:
(A) CASS Corrosion Resistance: 8h;
(B) Thermal Shock Loop: 4 loops;
(C) Falling Sand Impact: 12L of falling sand;
(D) Adhesion (Cross Cut): 5B;
(E) Water immersion at 38°C: 24h;
(F) Pencil Hardness (Mitsubishi): 2H;
(G) RCA Abrasion Resistance Test: 450 times.

In the third preferred embodiment, a BMC thermosetting plastic blank of a refrigerator handle coated with stainless steel is used as an example.
(1) BMC is injected to form a blank, and the blank is placed into a PVD furnace and processed by an ion source glow rinsing and activation (provided that the current of the ion source is 1A, the bias voltage is 100V, the gases used are 50SCCM of N₂ and 50SCCM of Ar₂, the vacuum pressure is 0.2Pa, and the activation time is 5min).
(2) An arc target in the PVD furnace is turned on, and chromium is plated on a surface of the BMC blank (provided that the current of the target source is 50A, the bias voltage is 100V, the flow of Ar₂ is 50SCCM, the vacuum pressure is 0.1Pa, and the chromium plating time is 10 min).
(3) A plasma activation is performed at the surface of the plastic blank which is coated with chromium (metal basal film) (provided that the current of the ion source is 2A, the bias voltage is 100V, the flow of the working gas is a mixed flow of Ar₂ and O₂, the mixing ratio is 50SCCM: 50SCCM, the vacuum pressure is 0.2Pa, and the activation time is 5 min).
(4) The blank is removed from the furnace and sprayed with a 60µm-thick powder layer. The coated powder layer is cured in an oven at 160°C for 20 min).
(5) The thermal cured blank is transferred into the PVD furnace and processed by a plasma gas activation (provided that the current of the ion source is 2A, the bias voltage is 100V, the vacuum pressure inside the furnace is 0.3Pa, the flow of the working gas is a mixed flow of Ar₂ and N₂, the mixing ratio is 50SCCM: 50SCCM, and the activation time is 5 min), and then an 1µm-thick metal (stainless steel) layer is plated onto the powder coating (wherein the conditions of plating the stainless steel layer include: the current of the sputtered stainless steel target is 10A, the bias voltage is 100V, the flow of Ar₂ is 50SCCM, the vacuum pressure is 0.1Pa, and the coating time is 40 min).

The product produced according to the aforementioned technology has a smooth flat surface and passes the following functional tests:
(A) CASS Corrosion Resistance: 64h;
(B) Thermal Shock Loop: 8 loops;
(C) Falling Sand Impact: 12L of falling sand;
(D) Adhesion (Cross Cut): 4A;
(E) Water immersion at 38°C: 24h;
(F) Pencil Hardness (Mitsubishi): 3H;
(G) RCA Abrasion Resistance Test: 500 times

In the fourth preferred embodiment, an application on a fiberglass reinforced PPO plastic substrate free of lead and copper is used as an example for the illustration of the invention.
(1) A blank made of the fiberglass reinforced (40%) PPO by plastic molding is sent into a PVD furnace, and processed by plasmas glow rinsing and activation (provided that the current of ion source is 1A, the bias voltage is 160V, the vacuum pressure is 0.2Pa, the gases are 50SCCM of Ar₂ and 50SCCM of O₂, and the activation time is 5min).
(2) A mid-frequency sputtering source in the PVD furnace is turned on, and a copper-zinc (Cu/Zn) alloy target (having a zinc content of 40%) is used and spattered onto a surface of the fiberglass reinforced PPO blank (provided that the current of the target source is 10A, the bias voltage is 110V, the vacuum pressure inside the furnace is 0.1Pa, the gas is 50SCCM of Ar₂, and the time of coating the alloy is 15min).
(3) A plasma activation of the surface of the copper alloy plated (which is the metal basal film) plastic blank is conducted (provided that the current of the ion source is 1A, the bias voltage is 160V, the vacuum pressure inside the furnace is 0.1Pa, and the activation time is 5min).
(4) The blank is removed from the furnace, a layer of 45µm-thick UV powder is sprayed, and an IR lamp is used to bake the paint layer at 120°C for 5min, and then a UV lamp is used to cure the blank (at 1100J/M²×40s).
(5) The cured blank is transferred into the PVD furnace and a plasma gas activation is carried out (provided that the current of the ion source is 1A, the bias voltage is 160V, the vacuum pressure inside the furnace is 0.2Pa, the flow of the working gas is a mixed flow of Ar₂ and N₂, the mixing ratio is 50SCCM: 50SCCM, and the activation time is 5min), and then a 0.5µm-thick Cu/Zn alloy layer is coated onto the paint layer (wherein the conditions of the mid-frequency sputtering include: the current of the alloy target is 10A, the bias voltage is 110V, the flow of Ar₂ is 30SCCM, the vacuum pressure is 0.1Pa, and the coating time is 35min).

The product produced according to the aforementioned technology has a smooth flat surface and passes the following functional tests:
(A) CASS Corrosion Resistance: 16h;
(B) Thermal Shock Loop: 4 loops;
(C) Falling Sand Impact: 12L of falling sand;
(D) Adhesion (Cross Cut): 5B;
(E) Water immersion at 38°C: 24h;
(F) Pencil Hardness (Mitsubishi): 2H;
(G) RCAAbrasion Resistance Test: 500 times.

In an embodiment, which is not in accordance with the invention, but helpful for the understanding thereof, a chromium plated faucet made of PA6 and added with fiberglass powder (enhanced PA6) is prepared.
(1) A blank made of enhanced PA6 by injection molding is placed in a PVD furnace and processed by plasma glow rinsing and activation (provided that the current of the ion source is 1A, the bias voltage is 100V, the flow of gases is a mixed flow of 50SCCM of Ar₂ and 50SCCM of O₂, the vacuum pressure is 0.2Pa, and the activation time is 5min).
(2) An arc target in the PVD furnace is turned on, and chromium is coated on the surface of the enhanced PA6 blank (provided that the current of the target power source is 100A, the bias voltage is 100V, the vacuum pressure is 0.2Pa, the gas is 50SCCM of Ar₂, and the chromium coating time is 20min).
(3) A plasma activation of the chromium coating (which is the metal basal film) at the surface of the blank is conducted (provided that the current of the ion source is 2A, the bias voltage is 100V, the flow of the working gases is a mixed flow of Ar₂ and O₂, the mixing ratio is 50SCCM: 50SCCM, the vacuum pressure is 0.2Pa, and the activation time is 5min).
(4) A layer of 40µm-thick electrophoretic paint is coated by electrophoretic deposition. The electrophoretic painted layer is baked and cured at 140°C for 20min in an oven.
(5) The thermally cured blank is transferred into the PVD furnace and processed by a plasma gas activation (provided that the current of the ion source is 2A, the bias voltage is 100V, the flow of the working gas is a mixed flow of Ar₂ and N₂, the mixing ratio is 50SCCM: 50SCCM, the vacuum pressure inside the furnace is 0.2Pa, and the activation time is 5min), and then a layer of 0.5µm-thick metal (Cr/Ni/Cr) is coated onto the electrophoretic paint layer (wherein the conditions of arc plating the chromium include: the current of chromium target and nickel target is 50A, the bias voltage is 100V, the gas is 50SCCM of Ar₂, the vacuum pressure is 0.2Pa, the coating time is 20min, the chromium coating time is 10min).

The product produced according to the invention has a smooth flat surface and passes the following functional tests:
(A) CASS Corrosion Resistance: 24h;
(B) thermal shock loop: 4 loops;
(C) Falling Sand Impact: 12L of falling sand;
(D) Adhesion (Cross Cut): 5B;
(E) Water immersion at 38°C: 24h;
(F) Pencil Hardness (Mitsubishi): 3H;
(G) RCA Abrasion Resistance Test: 500 times.

The aforementioned function tests include:
1. Corrosion Resistance Function Tests:
   (1) CASS Test (ASTM B368-09); and
   (2) AASS Test (ASTM G85-09).
2. Abrasion Resistance Function Test:
   Falling Sand Test (ASTM D968-05).
3. Adhesion Tests:
   (1) Cross Cut Adhesion Test (ASTM D3359-02); and
   (2) Thermal Loop Test (ASME A112.18.1-2005/CSA B125.1-05).
4. Weather Resistance Test:
   QUV Test (ASTM G154).
5. Water Resistance Test:
   Water Immersion Test (ASTM D870-02).
6. Scratch Resistance Tests:
   (1) Pencil Hardness Test (ASTM D3363-05); and
   (2) Scratch Resistance Test (ASTM D5178-9).
7. Chemical Resistance Test

Fig. 1 shows a cross-sectional view (amplified by 400X) of an included composite coating formed on an engineering plastic surface in accordance with a preferred embodiment of the present invention, wherein the numeral 1 stands for the metal film, the numeral 2 stands for the organic coating, the numeral 3 stands for the metal basal film, and the numeral 4 stands for the plastic substrate, and the uppermost layer is made of epoxy resin and used for a slice analysis.

Accordingly, to promote the progress in science and the useful arts, the invention is disclosed and is intended to be limited only by the scope of the appended claims.

## Claims

1. A method of preparing a sandwich composite coating on an engineering plastic surface, comprising the steps of:
(1) dry cleaning and activating a plastic blank (4);
(2) placing the activated plastic blank (4) into a physical vapor deposition (PVD) furnace, and forming a metal basal film (3) onto the activated plastic blank (4);
(3) performing a plasma activation of the plastic blank (4) with the metal basal film (3), and spraying an organic coating (2) and curing the organic coating (2);
(4) forming a metalized engineering plastic product by placing the plastic blank (4) obtained from step (3) in the PVD furnace and coating the plastic blank (4) with a metal film layer (1) to produce a metalized engineering plastic product,
wherein the organic coating (2) sprayed and cured during the step (3) has a thickness falling within a range of 5-60 µm.

2. The method of preparing a sandwich composite coating on an engineering plastic surface as recited in claim 1, wherein the plastic blank (4) described in the step (1) is made of thermoplastic or thermosetting plastic.

3. The method of preparing a sandwich composite coating on an engineering plastic surface as recited in claim 2, wherein the thermoplastic is one selected from the group of ABS, PC/ABS, HIPS, PC, PPO, PP, PBT, PPS, PERT, HDPE, PA6, PA66, ABS/TPU, and PMMA thermoplastics, and fiberglass reinforced ABS, PC/ABS, HIPS, PC, PPO, PP, PBT, PPS, PERT, HDPE, PA6, PA66, ABS/TPU and PMMA thermoplastics.

4. The method of preparing a sandwich composite coating on an engineering plastic surface as recited in claim 2, wherein the thermosetting plastic is BMC.

5. The method of preparing a sandwich composite coating on an engineering plastic surface as recited in claim 1, wherein the plastic blank (4) as described in step (1) is cleaned by using a dry cloth to wipe the plastic blank (4), and then the dried plastic blank (4) is sent into an electrostatic dust remover to blow away the dust.

6. The method of preparing a sandwich composite coating on an engineering plastic surface as recited in claim 1, wherein the cleaned and activated plastic blank (4) as described in the step (1) is transferred into a physical vapor deposition furnace and activated by a plasma gas.

7. The method of preparing a sandwich composite coating on an engineering plastic surface as recited in claim 1, wherein the metal as described in the step (2) is one selected from the group of copper, nickel, chromium, aluminum, stainless steel, zirconium, and titanium and metal compounds thereof; the metal basal film layer (3) has a thickness falling within a range of 0.05∼3µm; the metal basal film M1 formed on the activated plastic blank (4) requires a vacuum pressure of 5×10⁻³ Pa and a metal coating time falling within a range of 5∼60 min.; and the metal is coated onto the basal film layer by sputtering arc plating or evaporation deposition.

8. The method of preparing a sandwich composite coating on an engineering plastic surface as recited in claim 1, wherein step (3) comprises the steps of:
turning on an ion source in the PVD furnace, passing over of a protective gas, performing a plasma glow activation to the metal basal film layer (3), removing the plastic blank (4) from the PVD furnace, transferring and hanging the plastic blank (4) in a spray rotating line, sputtering a light curing paint or a baking a painted layer, sending the plastic blank (4) into an infrared oven, and performing a radiation curing crosslink or a thermal curing crosslink of the plastic blank in an ultraviolet curing furnace after the sprayed coating (2) is leveled and baked dry;
wherein the protective gas is one selected from the group of nitrogen, argon and oxygen; the plasma glow activation time falls within a range of 2∼10min; the paint layer has a thickness falling within a range of 5∼60µm; the baking temperature falls within a range of 40∼80°C, the baking time falls within a range of 3∼10min; the radiation curing crosslink time falls within a range of 10∼45s; the thermal curing crosslink temperature falls within a range of 70∼180°C and the thermal curing crosslink time falls within a range of 10∼90min; the organic coating (2) is sputtered by a liquid spray, electrophoretic deposition or powder spray method.

9. The method of preparing a sandwich composite coating on an engineering plastic surface as recited in claim 1, wherein the metal film layer (1) as described in the step (4) has a thickness falling within a range of 0.05∼3 µm, and the metal is one selected from the group of copper, nickel, chromium, aluminum, stainless steel, zirconium, and titanium and metal compounds thereof.

10. The method of preparing a sandwich composite coating on an engineering plastic surface as recited in claim 1, wherein the method of coating a metal onto the film layer as described in the step (4) comprises the steps of:
transferring the plastic blank (4) into the PVD furnace, turning on an ion source, passing over of a protective gas, and spraying the film layer to perform a plasma glow activation to plate a metal film after performing the curing process, turning off the ion source, turning on an arc target, sputtering the target or an evaporation power;
and the protective gas is one selected from the group of nitrogen, argon and oxygen;
and the plasma glow activation time falls within a range of 2∼10 minutes; and the time of arc plating the chromium falls within a range of 5∼60 minutes.

## Patentansprüche

1. Verfahren zur Herstellung einer Sandwich-Verbundbeschichtung auf einer Oberfläche eines technischen Kunststoffs, welches die Schritte umfasst:
(1) Trockenreinigung und Aktivierung eines Kunststoffrohlings (4),
(2) Platzieren des aktivierten Kunststoffrohlings (4) in einer Ofenanlage zur physikalischen Gasphasenabscheidung (physical vapor deposition, PVD) und Ausbilden eines Metallbasisfilms (3) auf dem aktivierten Kunststoffrohling (4),
(3) Durchführung einer Plasmaaktivierung des Kunststoffrohlings (4) mit dem Metallbasisfilm (3) und Aufsprühen einer organischen Beschichtung (2) und Aushärten der organischen Beschichtung (2),
(4) Ausbilden eines metallisierten Produkts aus technischem Kunststoff, dadurch, dass der Kunststoffrohling (4), der in dem Schritt (3) erhalten wurde, in der PVD - Ofenanlage platziert wird und der Kunststoffrohling (4) mit einer Metallfilmschicht (1) beschichtet wird, um ein metallisiertes Produkt aus technischem Kunststoff zu fertigen, wobei die organische Beschichtung (2), die während des Schritts (3) aufgesprüht und ausgehärtet wird, eine Dicke hat, die in einem Bereich von 5-60 µm liegt.

2. Verfahren zur Herstellung einer Sandwich-Verbundbeschichtung auf einer Oberfläche eines technischen Kunststoffs nach Anspruch 1, bei welchem der in dem Schritt (1) beschriebene Kunststoffrohling (4) aus einem thermoplastischen oder duroplastischen Kunststoff hergestellt ist.

3. Verfahren zur Herstellung einer Sandwich-Verbundbeschichtung auf einer Oberfläche eines technischen Kunststoffs nach Anspruch 2, bei welchem ein Thermoplast aus einer Gruppe ausgewählt ist, die ABS, PC/ABS, HIPS, PC, PPO, PP, PBT, PPS, PERT, HDPE, PA6, PA66, ABS/TPU und PMMA Thermoplaste, und glasfaser-verstärktes ABS, PC/ABS, HIPS, PC, PPO, PP, PBT, PPS, PERT, HDPE, PA6, PA66, ABS/TPU und PMMA Thermoplaste umfasst.

4. Verfahren zur Herstellung einer Sandwich-Verbundbeschichtung auf einer Oberfläche eines technischen Kunststoffs nach Anspruch 2, bei welchem der duroplastische Kunststoff BMC ist.

5. Verfahren zur Herstellung einer Sandwich-Verbundbeschichtung auf einer Oberfläche eines technischen Kunststoffs nach Anspruch 1, bei welchem der in dem Schritt (1) beschriebene Kunststoffrohling (4) dadurch gereinigt wird, dass ein Trockentuch verwendet wird, um den Kunststoffrohling (4) abzuwischen, wobei der getrocknete Kunststoffrohling (4) anschließend in einen elektrostatischen Staubentferner überführt wird, um den Staub wegzublasen.

6. Verfahren zur Herstellung einer Sandwich-Verbundbeschichtung auf einer Oberfläche eines technischen Kunststoffs nach Anspruch 1, bei welchem der gemäß dem Schritt (1) gereinigte und aktivierte Kunststoffrohling (4) in eine Ofenanlage zur physikalischen Gasphasenabscheidung überführt wird und durch ein Plasmagas aktiviert wird.

7. Verfahren zur Herstellung einer Sandwich-Verbundbeschichtung auf einer Oberfläche eines technischen Kunststoffs nach Anspruch 1, bei welchem das in dem Schritt (2) beschriebene Metall aus einer Gruppe ausgewählt ist, welche Kupfer, Nickel, Chrom, Aluminium, rostfreien Stahl, Zirkon und Titan und deren Metallverbindungen umfasst, wobei die Metallbasisfilmschicht (3) eine Dicke aufweist, die in einem Bereich von 0,05-3 µm liegt, wobei die Bildung des Metallbasisfilms M1 auf dem aktivierten Kunststoffrohling (4) einen Vakuumdruck von 5×10⁻³ Pa und eine Metallbeschichtungsdauer erfordert, die in einem Bereich von 5-60 min liegt, und wobei die Basisfilmschicht durch eine Lichtbogenzerstäubungsbeschichtung oder Abscheidung aus der Gasphase mit dem Metall beschichtet wird.

8. Verfahren zur Herstellung einer Sandwich-Verbundbeschichtung auf einer Oberfläche eines technischen Kunststoffs nach Anspruch 1, bei welchem Schritt (3) die Schritte umfasst:
Anschalten einer Ionenquelle in der PVD - Ofenanlage, Durchleiten eines Schutzgases, Durchführung einer Glimmplasmaaktivierung der Metallbasisfilmschicht (3), Entnehmen des Kunststoffrohlings (4) aus der PVD - Ofenanlage, Transfer und Aufhängen des Kunststoffrohlings (4) in einem sich drehenden Sprühsystem, Abscheiden eines lichthärtenden Anstrichs durch Zerstäuben oder Ausheizen einer Anstrichschicht, Überführen des Kunststoffrohlings (4) in einen Infrarotofen und Durchführung einer Lichthärtung zur Quervernetzung oder einer thermischen Aushärtung zur Quervernetzung des Kunststoffrohlings in einer Ofenanlage zur Aushärtung mittels ultraviolettem Licht nachdem die aufgesprühte Beschichtung (2) geebnet und zur Trocknung ausgeheizt wurde,
wobei das Schutzgas aus einer Gruppe ausgewählt ist, die Stickstoff, Argon und Sauerstoff umfasst, wobei die Glimmplasmaaktivierungsdauer in einem Bereich von 2∼10 min liegt, wobei die Anstrichschicht eine Dicke aufweist, die ein einem Bereich von 5-60 µm liegt, wobei die Ausheiztemperatur in einem Bereich von 40-80 °C liegt,
wobei die Ausheizdauer in einem Bereich von 3-10 min liegt, wobei die Quervernetzungszeit für die Lichthärtung in einem Bereich von 10-45 s liegt, wobei die Quervernetzungstemperatur zur thermischen Aushärtung in einem Bereich von 70-18 °C liegt und wobei die Quervernetzungszeit für die thermische Aushärtung in einem Bereich von 10-90 min liegt, wobei die organische Beschichtung (2) mittels eines Flüssigkeitssprays, elektrophoretischer Abscheidung oder einem Pulversprühverfahren aufgesprüht wird.

9. Verfahren zur Herstellung einer Sandwich-Verbundbeschichtung auf einer Oberfläche eines technischen Kunststoffs nach Anspruch 1, bei welchem die in dem Schritt (4) beschriebene Metallfilmschicht (1) eine Dicke aufweist, die in einem Bereich von 0,05-3 µm liegt, und wobei das Metall aus einer Gruppe ausgewählt ist, welche Kupfer, Nickel, Chrom, Aluminium, rostfreien Stahl, Zirkon und Titan und deren Metallverbindungen umfasst.

10. Verfahren zur Herstellung einer Sandwich-Verbundbeschichtung auf einer Oberfläche eines technischen Kunststoffs nach Anspruch 1, bei welchem das Verfahren zum Aufbringen einer Metallbeschichtung auf der Filmschicht, das in dem Schritt (4) beschrieben ist, die Schritte umfasst:
Transfer des Kunststoffrohlings (4) in die PVD - Ofenanlage, Anschalten einer Ionenquelle, Durchleiten eines Schutzgases und Aufsprühen der Filmschicht, um nach der Durchführung des Härtungsprozesses eine Glimmplasmaaktivierung zur Plattierung eines Metallfilms durchzuführen, Ausschalten der Ionenquelle, Anschalten eines Lichtbogentargets, Zerstäuben des Targets oder einer Verdampfungsquelle,
und wobei das Schutzgas aus einer Gruppe ausgewählt ist, die Stickstoff, Argon und Sauerstoff umfasst, und wobei die Glimmplasmaaktivierungsdauer in einem Bereich von 2∼10 Minuten liegt, und wobei die Dauer der Lichtbogenbeschichtung für Chrom in einem Bereich von 5-60 Minuten liegt.

## Revendications

1. Procédé de préparation d'un revêtement composite sandwich sur une surface d'une matière plastique technique comprenant les étapes de :
(1) nettoyage à sec et activation d'une ébauche en matière plastique (4) ;
(2) mise en place de l'ébauche en matière plastique activée (4) dans un four de dépôt physique à phase vapeur (PVD) et formation d'un film de base en métal (3) sur l'ébauche en matière plastique activée (4) ;
(3) réalisation d'une activation par plasma de l'ébauche en matière plastique (4) avec le film de base en métal (3) et vaporisation d'un revêtement organique (2) et durcissement du revêtement organique (2) ;
(4) formation d'un produit en plastique technique métallisé en plaçant l'ébauche en matière plastique (4) obtenue à l'étape (3) dans le four de PVD et revêtement de l'ébauche en matière plastique (4) avec une couche de film de métal (1) pour produire un produit plastique technique métallisé,
le revêtement organique (2) pulvérisé et durci pendant l'étape (3) ayant une épaisseur de l'ordre de 5 à environ 60 µm.

2. Procédé de préparation d'un revêtement composite sandwich sur une surface d'une matière plastique technique selon la revendication 1, l'ébauche en matière plastique (4) décrite à l'étape (1) étant en un plastique thermoplastique ou thermodurcissable.

3. Procédé de préparation d'un revêtement composite sandwich sur une surface d'une matière plastique technique selon la revendication 2, la matière thermoplastique étant sélectionnée dans le groupe comprenant l'ABS, le PC/ABS, l'HIPS, le PC, le PPO, le PP, le PBT, le PPS, le PERT, l'HDPE, le PA6, le PA66, l'ABS/TPU et les plastiques PPMA et l'ABS, le PC/ABS, l'HIPS, le PC, le PPO, le PP, le PBT, le PPS, le PERT, l'HDPE, le PA6, le PA66, l'ABS/TPU et les matières plastiques PPMA renforcées par des fibres de verre.

4. Procédé de préparation d'un revêtement composite sandwich sur une surface d'une matière plastique technique selon la revendication 2, la matière plastique thermodurcissable étant le BMC.

5. Procédé de préparation d'un revêtement composite sandwich sur une surface d'une matière plastique technique selon la revendication 1, l'ébauche en matière plastique (4) telle que décrite à l'étape (1) étant nettoyée en utilisant un chiffon sec pour essuyer l'ébauche en matière plastique (4) et ensuite l'ébauche en matière plastique séchée (4) est envoyée dans un dépoussiéreur à électricité statique pour souffler la poussière.

6. Procédé de préparation d'un revêtement composite sandwich sur une surface d'une matière plastique technique selon la revendication 1, l'ébauche en matière plastique nettoyée et activée (4) telle que décrite à l'étape (1) étant transférée dans un four de dépôt physique à phase vapeur et activée par un gaz plasma.

7. Procédé de préparation d'un revêtement composite sandwich sur une surface d'une matière plastique technique selon la revendication 1, le métal tel que décrit à l'étape (2) étant sélectionné dans le groupe comprenant le cuivre, le nickel, le chrome, l'aluminium, l'acier inoxydable, le zirconium, le titane et les composés métalliques de ceux-ci, la couche de film de base en métal (3) ayant une épaisseur de l'ordre de 0,05 à 3 µm, le film de base en métal M1 étant formé sur l'ébauche en matière plastique activée (4) requérant une pression sous vide de 5x10⁻³ Pa et un temps de revêtement du métal de l'ordre de 5 à environ 60 minutes et le métal étant revêtu sur la couche de film de base par placage par pulvérisation à l'arc ou dépôt par évaporation.

8. Procédé de préparation d'un revêtement composite sandwich sur une surface d'une matière plastique technique selon la revendication 1, l'étape (3) comprenant les étapes de : mise en marche d'une source d'ions dans le four de PVD, passage d'un gaz protecteur, réalisation d'une activation plasma par décharge sur la couche de film de base en métal (3), enlèvement de l'ébauche en matière plastique (4) du four de PVD, transfert et suspension de l'ébauche en matière plastique (4) dans une ligne de pulvérisation rotative, pulvérisation d'une peinture photopolymérisable ou cuisson d'une couche peinte, envoi de l'ébauche en matière plastique (4) dans un four à infrarouge et réalisation d'une réticulation par durcissement par rayonnement ou réticulation par durcissement thermique de l'ébauche en matiére plastique dans un tour de trempe ultraviolet après que le revêtement pulvérisé (2) soit égalisé, cuit et séché,
le gaz protecteur étant sélectionné dans le groupe comprenant le nitrogène, l'argon et l'oxygène, le temps d'activation plasma par décharge étant de l'ordre de 2 à environ 10 minutes, la couche de peinture ayant une épaisseur de l'ordre de 5 à environ 60 µm, la température de cuisson étant de l'ordre de 40 à environ 80°C, le temps de cuisson étant de l'ordre de 3 à environ 10 minutes, le temps de réticulation par durcissement par rayonnement étant de l'ordre de 10 à environ 45 secondes, la température de réticulation par durcissement thermique étant de l'ordre de 70 à environ 180°C et le temps de réticulation par durcissement thermique étant de l'ordre de 10 à environ 90 minutes, le revêtement organique (2) étant pulvérisé par un spray liquide, cataphorèse ou pulvérisation de poudre.

9. Procédé de préparation d'un revêtement composite sandwich sur une surface d'une matière plastique technique selon la revendication 1, la couche de film de métal (1) telle que décrite à l'étape (4) ayant une épaisseur de l'ordre de 0,05 à environ 3 µm et le métal étant sélectionné dans le groupe comprenant le cuivre, le nickel, le chrome, l'aluminium, l'acier inoxydable, le zirconium, le titane et les composés métalliques de ceux-ci.

10. Procédé de préparation d'un revêtement composite sandwich sur une surface d'une matière plastique technique selon la revendication 1, le procédé de revêtement d'un métal sur la couche de film tel que décrit à l'étape (4) comprenant les étapes de :
transfert de l'ébauche en matière plastique (4) dans le four de PVD, mise en marche d'une source d'ions, passage d'un gaz protecteur et pulvérisation de la couche de film pour réaliser une activation plasma par décharge pour plaquer un film de métal après réalisation du processus de durcissement, arrêt de la source d'ions, mise en marche d'un arc cible, pulvérisation de la cible ou d'une puissance d'évaporation
et le gaz protecteur étant sélectionné dans le groupe comprenant le nitrogène, l'argon et l'oxygène, le temps d'activation plasma par décharge étant de l'ordre de 2 à environ 10 minutes et le temps de placage à l'arc du chrome étant de l'ordre de 5 à environ 60 minutes.
